# EUROPEAN PATENT APPLICATION

(11) **EP 4 683 465 A2**
(43) Date of publication of application: **21.01.2026**
(21) Application number: 25215765.6
(22) Date of filing: 14.11.2025
(51) Int. Cl.: H10F 77/20, H10F 19/90, H10F 71/00

(54) **BACK-CONTACT SOLAR CELL, PREPARATION METHOD THEREOF, AND PHOTOVOLTAIC MODULE**

(30) Priority: 06.01.2025 CN 202510023377
(71) Applicant: Zhejiang Jinko Solar Co., Ltd., Haining, Zhejiang 314416 (CN); Jinko Solar (Haining) Co., Ltd., Haining City, Zhejiang 314415 (CN)
(72) Inventor: ZHANG, Chenming, YUAN HUA TOWN, HAINING, ZHEJIANG, 314416 (CN); XIA, Zhipeng, YUAN HUA TOWN, HAINING, ZHEJIANG, 314416 (CN); LU, Sitian, YUAN HUA TOWN, HAINING, ZHEJIANG, 314416 (CN); HUANG, Jide, YUAN HUA TOWN, HAINING, ZHEJIANG, 314416 (CN); LIU, Changming, YUAN HUA TOWN, HAINING, ZHEJIANG, 314416 (CN); ZHANG, Xinyu, YUAN HUA TOWN, HAINING, ZHEJIANG, 314416 (CN); JIN, Hao, YUAN HUA TOWN, HAINING, ZHEJIANG, 314416 (CN)
(74) Representative: Herrero & Asociados, S.L.

(57) **Abstract**

A back-contact solar cell, a preparation method thereof, and a photovoltaic module are provided. The back-contact solar cell includes: a solar cell base, a back surface of the solar cell base including a first edge region, a central region, and a second edge region; first finger electrodes and second finger electrodes located in the central region and alternately arranged; an edge busbar located in the first edge region or the second edge region and connected to the first finger electrodes or the second finger electrodes; an edge solder pad located on a portion of at least one finger electrode adjacent to the first edge region or the second edge region; and a connecting member, an orthographic projection of the connecting member on the back surface having a wavy shape.

## Description

### TECHNICAL FIELD

The present disclosure relates to the photovoltaic field, and in particular, to a back-contact solar cell, a preparation method thereof, and a photovoltaic module.

### BACKGROUND

Currently, with the gradual depletion of fossil energy, photovoltaic cells, as a new energy alternative, are increasingly widely used. Photovoltaic cells are devices that convert solar energy into electrical energy, utilizing the photovoltaic effect to generate charge carriers, which are then extracted through electrodes, thereby facilitating the effective utilization of electrical energy.

The factors affecting the photoelectric conversion efficiency and the yield of photovoltaic cells mainly include the following two aspects: first, optical losses, which include but are not limited to shading losses, carrier recombination losses in the substrate, carrier recombination losses in highly doped films and layers, and refractive losses of the films and layers; second, electrical losses, which include but are not limited to resistive losses of the materials themselves, contact losses of the electrodes, contact losses between the solder ribbons and the photovoltaic cell, losses due to poor soldering between the solder ribbons and the photovoltaic cell, etc.

Therefore, there is an urgent need in the field to provide a photovoltaic cell and a photovoltaic module that can reduce electrical losses and/or optical losses, thereby improving the photoelectric conversion efficiency of the photovoltaic cell and the yield of the photovoltaic module.

### SUMMARY

The embodiments of the present disclosure provide a back-contact solar cell, a method for preparing the same, and a photovoltaic module, which are at least conducive to improving the photoelectric conversion efficiency of the back-contact solar cell.

According to some embodiments of the present disclosure, an aspect of the embodiments of the present disclosure provides a back-contact solar cell, including a solar cell base, first finger electrodes, second finger electrodes, an edge busbar, an edge solder pad, and a connecting member. A back surface of the solar cell base includes a first edge region, a central region, and a second edge region sequentially arranged along a first direction. The first finger electrodes and the second finger electrodes are located in the central region and alternately arranged along a second direction. The edge busbar extends along the second direction, located in the first edge region or the second edge region, and connected to the first finger electrodes or the second finger electrodes. The edge solder pad is located on a portion of at least one finger electrode adjacent to the first edge region or the second edge region and electrically connected to the edge busbar, wherein the finger electrode is one of the first finger electrode or the second finger electrode. An orthographic projection of the connecting member on the back surface has a wavy shape. One end of the connecting member is connected to a side of the edge solder pad adjacent to the edge busbar or to one of two opposite sides of the edge solder pad along the second direction; and another end of the connecting member is connected to the edge busbar or to one finger electrode.

In some embodiments, the connecting member includes at least one first connecting member and/or at least one second connecting member. The first connecting member includes a plurality of first bent segments sequentially connected along the first direction, in two ends of the first connecting member opposite along the first direction, one end being connected to the edge busbar, and the other end being connected to the edge solder pad. The second connecting member includes a plurality of second bent segments sequentially connected along the second direction, in two ends of the second connecting member opposite along the second direction, one end being connected to the edge solder pad, and the other end being connected to the one finger electrode.

In some embodiments, the edge solder pad includes a first solder pad and a second solder pad. The first solder pad is electrically connected to the first finger electrodes and electrically insulated from the second finger electrodes, and the second solder pad is electrically connected to the second finger electrodes and electrically insulated from the first finger electrodes. The second connecting member connected to the first solder pad is also connected to at least one first finger electrode. The second connecting member connected to the second solder pad is also connected to at least one second finger electrode.

In some embodiments, the back-contact solar cell further includes a widen edge portion extending along the first direction. One end of the widen edge portion is connected to the edge busbar, and the other end of the widen edge portion is connected to the edge solder pad, and along the second direction, a first width of the widen edge portion is greater than a second width of the finger electrode connected to the edge solder pad; and/or at least one first connecting member is disposed on each of two opposite sides of the widen edge portion along the second direction, and along the first direction, the first connecting member is aligned with a finger electrode that is electrically insulated from the edge solder pad.

In some embodiments, the solar cell base includes a substrate and a passivation layer located on a surface of the substrate, wherein the connecting member and the finger electrodes are all partially embedded in the passivation layer.

In some embodiments, one edge solder pad is electrically connected to one of the first finger electrodes or the second finger electrodes and electrically insulated from the other of the second finger electrodes or the first finger electrodes. At least one finger electrode adjacent to the edge solder pad and electrically insulated from the edge solder pad has a disconnection point, and the edge solder pad or the connecting member is located at the disconnection point of the finger electrode. The back-contact solar cell further includes a connection electrode, wherein in two ends of the connection electrode opposite along the second direction, one end is connected to the finger electrode having the disconnection point, and the other end is connected to another finger electrode adjacent to the finger electrode having the disconnection point along the second direction.

According to some embodiments of the present disclosure, another aspect of the embodiments of the present disclosure further provides a method for preparing a back-contact solar cell, including:
providing a solar cell base, a back surface of the solar cell base including a first edge region, a central region, and a second edge region sequentially arranged along a first direction;
forming first finger electrodes, second finger electrodes, and a connecting member in the central region, wherein the first finger electrodes and at least part of the connecting member are formed in a same preparation process, and/or the second finger electrodes and at least part of the connecting member are formed in another same preparation process, the first finger electrodes and the second finger electrodes being alternately arranged along a second direction, and an orthographic projection of the connecting member on the back surface having a wavy shape;
forming an edge busbar in the first edge region or the second edge region, the edge busbar extending along the second direction and being connected to the first finger electrodes or the second finger electrodes;
forming an edge solder pad, the edge solder pad being located on a portion of at least one finger electrode adjacent to the first edge region or the second edge region and electrically connected to the edge busbar, the finger electrode being one of the first finger electrode or the second finger electrode;
wherein one end of the connecting member is connected to a side of the edge solder pad adjacent to the edge busbar or to one of two opposite sides of the edge solder pad along the second direction; and another end of the connecting member is connected to the edge busbar or to one finger electrode.

In some embodiments, the step of forming the connecting member includes:
providing a first screen and printing a paste on the first screen to form at least one first connecting member, the first connecting member including a plurality of first bent segments sequentially connected along the first direction, in two ends of the first connecting member opposite along the first direction, one end being connected to the edge busbar, and the other end being connected to the edge solder pad; and/or
providing a second screen and printing a paste on the second screen to form at least one second connecting member, the second connecting member including a plurality of second bent segments sequentially connected along the second direction, in two ends of the second connecting member opposite along the second direction, one end being connected to the edge solder pad, and the other end being connected to the one finger electrode;
wherein the connecting member includes the at least one first connecting member and/or the at least one second connecting member.

In some embodiments, the step of providing the first screen includes: providing the first screen having at least one first opening, wherein one first opening is configured to form one first connecting member, the first opening including a plurality of first sub-openings sequentially communicated along the first direction, and two adjacent first sub-openings are arranged along the second direction and staggered with each other; and/or
the step of providing the second screen includes: providing the second screen having at least one second opening, wherein one second opening is configured to form one second connecting member, the second opening including a plurality of second sub-openings sequentially communicated along the second direction, and two adjacent second sub-openings are arranged along the first direction and staggered with each other.

According to some embodiments of the present disclosure, yet another aspect of the embodiments of the present disclosure further provides a photovoltaic module, including a solar cell string, an encapsulant film, and a cover plate. The solar cell string including a plurality of back-contact solar cells as described in any one of the above embodiments, or a plurality of back-contact solar cells prepared by the preparation method as described in any one of the above embodiments, wherein the plurality of back-contact solar cells are connected with each other. The encapsulant film is configured to cover a surface of the solar cell string. The cover plate is configured to cover a surface of the encapsulant film facing away from the solar cell string.

The technical solutions provided by the embodiments of the present disclosure possess at least the following advantages:

On the one hand, the electric current is transmitted from the edge busbar or finger electrodes to the edge solder pad through the connecting member, which forms more current flow paths on the back surface, thereby enhancing the current collection efficiency of the edge solder pad. On the other hand, the orthographic projection of the connecting member on the back surface has a wavy shape, which, as compared with the substantially straight-line shaped orthographic projection of a finger electrode, increases the cross-sectional area of the connecting member itself, the contact area between the connecting member and the edge solder pad, as well as the contact area between the connecting member and the edge busbar or the finger electrode, thereby improving the current transmission efficiency of the connecting member and further reducing the transmission resistance during current transmission from the edge busbar or the finger electrode to the edge solder pad. As a result, these combined effects contribute to enhancing the current collection efficiency of the back-contact solar cell, thereby improving the photoelectric conversion efficiency of the solar cell.

Additionally, on the one hand, the orthographic projection of the connecting member on the back surface has a wavy shape, which, as compared with the substantially straight-line shaped orthographic projection of a finger electrode, not only reduces the risk of breaking the connecting member under stress but also reduces the risk of disconnection between the connecting member and the edge solder pad, as well as between the connecting member and the edge busbar or the finger electrode. On the other hand, the edge solder pad is not disposed on but electrically connected to the edge busbar, which allows a solder ribbon connected to the edge solder pad not to be located in the first edge region or the second edge region, thereby preventing micro-cracking issues on the edge of the back-contact solar cell. As a result, these combined effects contribute to improving the yield of the back-contact solar cell.

### BRIEF DESCRIPTION OF THE DRAWINGS

One or more embodiments are exemplarily illustrated through the drawings corresponding thereto. These exemplary illustrations do not constitute a limitation on the embodiments. Unless specifically stated, the drawings do not impose scale restrictions. To more clearly illustrate the technical solutions in the embodiments of the present disclosure or in conventional art, the drawings used in the embodiments are briefly described below. Apparently, the drawings described below are merely for some embodiments of the present disclosure. For those of ordinary skill in the art, other drawings can be obtained according to the disclosed drawings without any creative effort.
FIG. 1 is a schematic top partial view of a back-contact solar cell provided by an embodiment of the present disclosure.
FIG. 2 is a schematic top partial view of a back-contact solar cell, corresponding to an edge solder pad, provided by an embodiment of the present disclosure.
FIG. 3 is a schematic top partial view of a back-contact solar cell, corresponding to an edge solder pad, provided by another embodiment of the present disclosure.
FIG. 4 is a schematic top view of a first connecting member in a back-contact solar cell provided by an embodiment of the present disclosure.
FIG. 5 is a schematic top view of a second connecting member in a back-contact solar cell provided by an embodiment of the present disclosure.
FIG. 6 is a schematic cross-sectional partial view of the back-contact solar cell shown in FIG. 3 along the first cross-sectional direction A-A1.
FIG. 7 is a schematic top view of a connection electrode in a back-contact solar cell provided by an embodiment of the present disclosure.
FIG. 8 is a schematic top partial view of a first screen in a method for preparing a back-contact solar cell provided by another embodiment of the present disclosure.
FIG. 9 is a schematic top partial view of a second screen in a method for preparing a back-contact solar cell provided by another embodiment of the present disclosure.
FIG. 10 is a schematic structural perspective partial view of a photovoltaic module provided by yet another embodiment of the present disclosure.
FIG. 11 is a schematic cross-sectional partial view of the photovoltaic module shown in FIG. 10 along the second cross-sectional direction B-B1.

### DETAILED DESCRIPTION

As known from the background, the photoelectric conversion efficiency of photovoltaic cells needs to be improved.

The embodiments of the present disclosure provide a back-contact solar cell, a method for preparing the same, and a photovoltaic module. In the back-contact solar cell, the electric current is transmitted from the edge busbar or finger electrodes to the edge solder pad through the connecting member, which forms more current flow paths on the back surface, thereby enhancing the current collection efficiency of the edge solder pad. Further, the orthographic projection of the connecting member on the back surface has a wavy shape, which, as compared with the substantially straight-line shaped orthographic projection of a finger electrode, increases the cross-sectional area of the connecting member itself, the contact area between the connecting member and the edge solder pad, as well as the contact area between the connecting member and the edge busbar or the finger electrode, thereby improving the current transmission efficiency of the connecting member and further reducing the transmission resistance during current transmission from the edge busbar or the finger electrode to the edge solder pad. As a result, these combined effects contribute to enhancing the current collection efficiency of the back-contact solar cell, thereby improving the photoelectric conversion efficiency of the solar cell. Additionally, the orthographic projection of the connecting member on the back surface has a wavy shape, which, as compared with the substantially straight-line shaped orthographic projection of a finger electrode, not only reduces the risk of breaking the connecting member under stress but also reduces the risk of disconnection between the connecting member and the edge solder pad, as well as between the connecting member and the edge busbar or the finger electrode. Furthermore, the edge solder pad is not disposed on but electrically connected to the edge busbar, which allows a solder ribbon connected to the edge solder pad not to be located in the first edge region or the second edge region, thereby preventing micro-cracking issues on the edge of the back-contact solar cell. As a result, these combined effects contribute to improving the yield of the back-contact solar cell.

In the description of the embodiments of the present disclosure, technical terms such as "first" and "second" are used merely to distinguish different objects and should not be construed as indicating or implying relative importance, or implying the number, specific order, or hierarchical relationship of the indicated technical features. In the description of the embodiments of the present disclosure, the term "a plurality of" means two or more, unless explicitly and specifically defined otherwise.

An "embodiment" in the present disclosure means that specific features, structures, or characteristics described with reference to the embodiment can be included in at least one embodiment of the present disclosure. This term mentioned in various places in the description do not necessarily refer to the same embodiment, nor an independent or alternative embodiment mutually exclusive with other embodiments. It can be explicitly and implicitly understood by those skilled in the art that the embodiments described herein can be combined with other embodiments.

In the description of the embodiments of the present disclosure, the term "and/or" merely describes an associative relationship between objects, indicating that three relationships may exist. For example, A and/or B may indicate: A exists alone, A and B exist simultaneously, or B exists alone. Additionally, the character "/" used herein generally indicates that the associated objects have an "or" relationship.

In the description of the embodiments of the present disclosure, the term "a plurality of" refers to two or more (including two), similarly, "a plurality of groups" refers to two or more groups (including two groups), and "a plurality of pieces" refers to two or more pieces (including two pieces).

In the description of the embodiments of the present disclosure, the terms "central", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. indicate the orientations or positional relationships on the basis of the drawings. These terms are only for describing the embodiments of the present disclosure and simplifying the description, rather than indicating or implying that the indicated devices or elements must have the specific orientations, or be constructed or operated in the specific orientations, and therefore cannot be understood as limitations of the embodiments of the present disclosure.

In the description of the embodiments of the present disclosure, unless otherwise clearly specified and defined, the terms "installed", "connected", "coupled", "fixed" and the like should be interpreted broadly. For example, the elements can be fixedly connected, detachably connected, or integrated, can be mechanically connected or electrically connected, can be directly connected or connected via an intermediate element, and can be internally communicated or interacted with each other. For those of ordinary skill in the art, the specific meaning of the above-mentioned terms in the present disclosure can be understood according to specific circumstances.

In the drawings corresponding to the embodiments of the present disclosure, for better understanding and ease of description, the thickness and area of layers are exaggerated. When a component (such as a layer, film, region, or substrate) is described as being "on" or "on the surface of" another component, the component can be "directly" on the surface of the other component, or a third component may exist between the two components.

In the description of the embodiments of the present disclosure, when a component "includes" another component, unless otherwise specified, it does not exclude other components, and additional components may be further included. Additionally, when a component such as a layer, film, region, or plate is referred to as being "on" or "located on" another component, it may be "directly on" the other component (i.e., no other component exists therebetween), or another component may be present therebetween. Furthermore, when a component such as a layer, film, region, or plate is "directly located on" another component, or when a component is located on the surface of another component, it indicates that no other component is present therebetween.

The terms used in the description of the various embodiments herein are merely used to describe specific embodiments and are not intended to be limiting. As used in the description of the various embodiments and the appended claims, "the component" is intended to include the plural form, unless the context clearly indicates otherwise. Here, components include layers, films, regions, plates, or the like.

In the present application, the solar cell base can include a substrate and one or more layers disposed on a surface of the substrate. The substrate can be a silicon substrate. The layers include, but are not limited to, a passivation layer, an anti-reflection layer, a protective layer, or other functional layers. For example, the solar cell base includes a silicon substrate and a passivation layer disposed on a surface of the substrate. For another example, the solar cell base includes a silicon substrate, a passivation layer and an anti-reflection layer, and the passivation layer and the anti-reflection layer are stacked on a surface of the substrate. When multiple layers are disposed on the surface of the substrate, the multiple layers may be of the same or different functional types. In some cases, the solar cell base can also be referred to as the solar cell body.

The embodiments of the present disclosure will be described in detail below with reference to the accompanying drawings. However, those of ordinary skill in the art can understand that, in the embodiments of the present disclosure, numerous technical details are provided to allow readers to better understand the embodiments of the present disclosure. Nevertheless, even without these technical details and various changes and modifications based on the following embodiments, the technical solutions claimed by the embodiments of the present disclosure can still be achieved.

An embodiment of the present disclosure provides a back-contact solar cell. The back-contact solar cell provided by the embodiment of the present disclosure will be described in detail below with reference to the accompanying drawings.

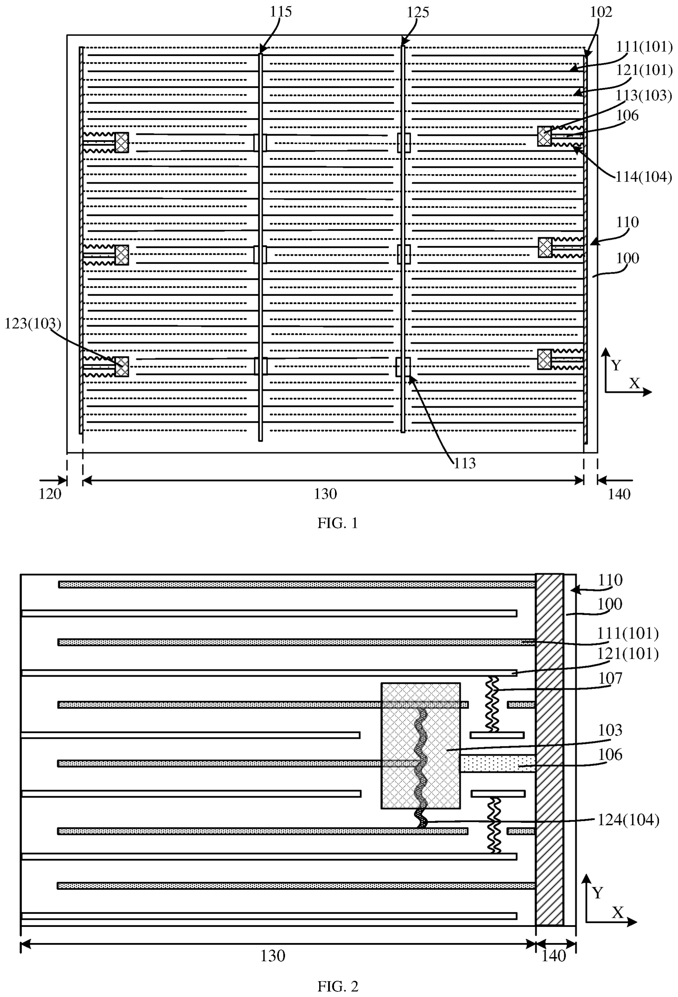

Referring to FIG. 1, FIG. 2, or FIG. 3, the back-contact solar cell includes a solar cell base 100, first finger electrodes 111, second finger electrodes 121, an edge busbar 102, an edge solder pad 103, and a connecting member 104. The back surface 110 of the solar cell base 100 includes a first edge region 120, a central region 130, and a second edge region 140 sequentially arranged along a first direction X. The first finger electrodes 111 and the second finger electrodes 121 are located in the central region 130 and alternately arranged along a second direction Y. The edge busbar 102 extends along the second direction Y, located in the first edge region 120 or the second edge region 140, and connected to the first finger electrodes 111 or the second finger electrodes 121. The edge solder pad 103 is located on a portion of at least one finger electrode 101 adjacent to the first edge region 120 or the second edge region 140 and electrically connected to the edge busbar 102, wherein the finger electrode 101 is one of the first finger electrode 111 and the second finger electrode 121. An orthographic projection of the connecting member 104 on the back surface 110 has a wavy shape. One end of the connecting member 104 is connected to a side of the edge solder pad 103 adjacent to the edge busbar 102 or to one of two opposite sides of the edge solder pad 103 along the second direction Y; and the other end of the connecting member 104 is connected to the edge busbar 102 or to one finger electrode 101. For convenience of description herein, in some cases, the first finger electrode 111 and the second finger electrode 121 are collectively referred to the finger electrode 101. In other words, when the finger electrode 101 is mentioned individually, it refers to either the first finger electrode 111 or the second finger electrode 121. For example, "at least one of the finger electrodes 101" refers to at least one of the first finger electrode 111 or at least one of the second finger electrode 121. For another example, "one finger electrode 101" refers to one first finger electrode 111 or one second finger electrode 121. A person skilled in the art can determine its intended meaning based on the context.

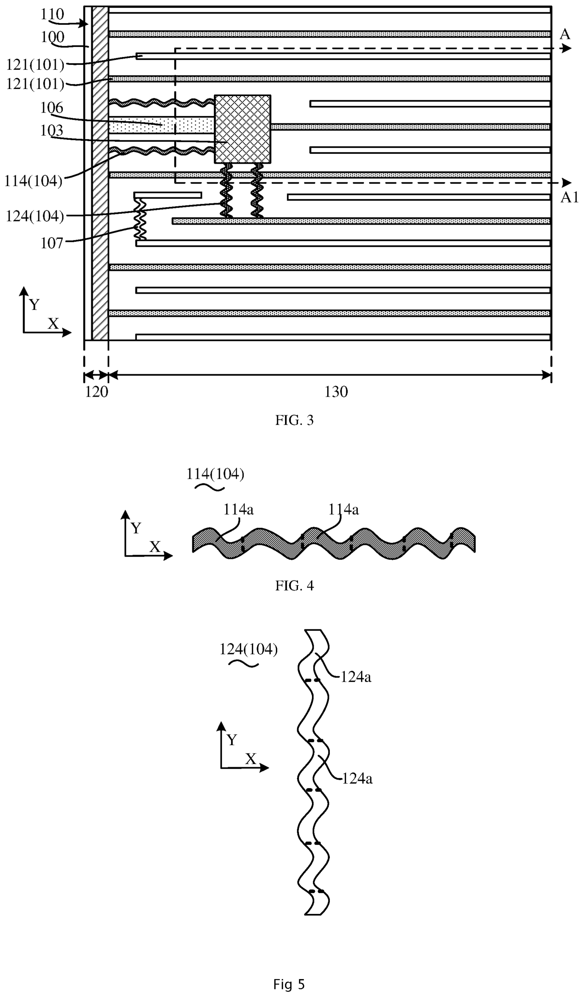

FIG. 1 is a schematic top partial view of a back-contact solar cell provided by an embodiment of the present disclosure. FIG. 2 is a schematic top partial view of a back-contact solar cell, corresponding to an edge solder pad, provided by an embodiment of the present disclosure. FIG. 3 is a schematic top partial view of a back-contact solar cell, corresponding to an edge solder pad, provided by another embodiment of the present disclosure. It should be noted that, to distinguish between the first finger electrodes 111 and the second finger electrodes 121, in FIG. 1, the first finger electrodes 111 are illustrated with solid lines, and the second finger electrodes 121 are illustrated with dashed lines. In FIG. 2 and FIG. 3, the drawings of the first finger electrodes 111 and the second finger electrodes 121 are filled up with different fill patterns, and in FIG. 2, the edge solder pad 103 is drawn in a translucent manner.

It is to be noted that the edge solder pad 103 is located on a portion of at least one finger electrode 101 adjacent to the first edge region 120 or the second edge region 140 and is electrically connected to the edge busbar 102. In other words, there is no edge solder pad located on the edge busbar 102. The edge busbar 102 collects electric current from the plurality of first finger electrodes 111 or the plurality of second finger electrodes 121 connected thereto and further conduct the electric current to the edge solder pad 103, which is electrically connected to the edge busbar 102 but is not located in the edge region. In the subsequent stage of preparing a photovoltaic module using the solar cell, a solder ribbon can be positioned on the edge solder pad 103 to collect the current gathered from the edge busbar 102, so that the solder ribbon can be positioned in the central region with the edge solder pad 103, rather than in the edge region, avoiding micro-cracking issues on the edge of the back-contact solar cell caused by the solder ribbon being located in the edge region, i.e., the first edge region 120 or the second edge region 140, thereby contributing to improving the yield of the subsequently formed photovoltaic module based on the improved back-contact solar cell.

To enhance the current collection efficiency from the finger electrodes 101 or the edge busbar 102 by the edge solder pad 103, on the one hand, the electric current is transmitted from the edge busbar 102 or finger electrodes 101 to the edge solder pad 103 through the connecting member 104, which forms more current flow paths on the back surface 110 through the connecting member 104, thereby enhancing the current collection efficiency of the edge solder pad 103. On the other hand, the orthographic projection of the connecting member 104 on the back surface 110 has a wavy shape, which, as compared with the substantially straight-line shaped orthographic projection of a finger electrode 101, increases the cross-sectional area of the connecting member 104 itself, decreasing the transmission resistance and improving the current transmission efficiency of the connecting member 104 itself. In addition, both the contact area between the connecting member 104 and the edge solder pad 103 and the contact area between the connecting member 104 and the edge busbar 102 or the finger electrode 101 can be increased, reducing the contact resistance between the connecting member 104 and the edge solder pad 103, and reducing the contact resistance between the connecting member 104 and the edge busbar 102 or the finger electrode 101, thereby further reducing the transmission resistance during current transmission from the edge busbar 102 or the finger electrode 101 to the edge solder pad 103. As a result, these combined effects contribute to enhancing the current collection efficiency of the back-contact solar cell, thereby improving the photoelectric conversion efficiency of the solar cell.

Additionally, the orthographic projection of the connecting member 104 on the back surface 110 has a wavy shape, which, as compared with the substantially straight-line shaped orthographic projection of a finger electrode 101, not only reduces the risk of breaking the connecting member 104 under stress due to the larger cross-sectional area of the connecting member 104 but also reduces the risk of disconnection between the connecting member 104 and the edge solder pad 103 due to the larger contact area therebetween, as well as reducing the risk of disconnection between the connecting member 104 and the edge busbar 102 or the finger electrode 101 due to the larger contact area therebetween. As a result, these combined effects contribute to improving the yield of the back-contact solar cell.

It should be noted that the solar cell base 100 can be a back-contact solar cell with busbar electrodes or a back-contact solar cell without busbar electrodes. Regardless of whether busbar electrodes are provided on the solar cell base 100, there is a need to collect the current from the finger electrodes 101 for utilization. On this basis, solder pads or solder joints are formed on at least a portion of finger electrodes 101, along with solder ribbons electrically connected with the solder pads or solder joints, wherein the solder pads or solder joints are all located in the central region 130. Since a finger electrode 101 can be either the first finger electrode 111 or the second finger electrode 121, the solder ribbons can also be divided into two types: one type is electrically connected to the first finger electrodes 111 and electrically insulated from the second finger electrodes 121 to collect current from the first finger electrodes 111, while the other type is electrically connected to the second finger electrodes 121 and electrically insulated from the first finger electrodes 111 to collect current from the second finger electrodes 121. Any given solder ribbon is electrically connected to either the first finger electrodes 111 or the second finger electrodes 121.

The back-contact solar cell with busbar electrodes and the back-contact solar cell without busbar electrodes as the solar cell base 100 are described respectively as follows.

In some embodiments, referring to FIG. 1, the solar cell base 100 can be a back-contact solar cell with busbar electrodes. The back-contact solar cell can further include first busbar electrodes 115 and second busbar electrodes 125 alternately arranged along the first direction X, wherein the first busbar electrodes 115 are electrically connected to the first finger electrodes 111 and configured to collect current from all the first finger electrodes 111, and the second busbar electrodes 125 are electrically connected to the second finger electrodes 121 and configured to collect current from all the second finger electrodes 121. The first busbar electrodes 115 are electrically insulated from the second finger electrodes 121, and the second busbar electrodes 125 are electrically insulated from the first finger electrodes 111. On this basis, the second finger electrodes 121 are disconnected at the first busbar electrodes 115, and the first finger electrodes 111 are disconnected at the second busbar electrodes 125. The disconnection points of the second finger electrodes 121 allow the first busbar electrodes 115 to extend along the second direction Y and electrically connect to the first finger electrodes 111. The disconnection points of the first finger electrodes 111 allow the second busbar electrodes 125 to extend along the second direction Y and electrically connect to the second finger electrodes 121.

It should be noted that, in FIG. 1, the solder pads in contact with the first busbar electrodes 115 or the second busbar electrodes 125 are named as central solder pads 113, and in FIG. 1, the edge solder pads 103 and the central solder pads 113 are drawn with different fill patterns.

In some other embodiments, the solar cell base 100 can be a back-contact solar cell without busbar electrodes. The back-contact solar cell can further include first solder ribbons and second solder ribbons alternately arranged along the first direction. The first solder ribbons are electrically connected to the first finger electrodes and configured to collect current from all the first finger electrodes, and the second solder ribbons are electrically connected to the second finger electrodes 111 and configured to collect current from all the second finger electrodes. The first solder ribbons are electrically insulated from the second finger electrodes, and the second solder ribbons are electrically insulated from the first finger electrodes. On this basis, the second finger electrodes are disconnected at the first solder ribbons, and the first finger electrodes are disconnected at the second solder ribbons. The disconnection points of the second finger electrodes allow the first solder ribbons to extend along the second direction and electrically connect to the first finger electrodes. The disconnection points of the first finger electrodes allow the second solder ribbons to extend along the second direction and electrically connect to the second finger electrodes.

It is to be noted that in the above two embodiments, the busbar electrodes or solder ribbons are all located in the central region 130. For the finger electrodes 101 disconnected by the busbar electrode or solder ribbon that is most adjacent to the first edge region 120, the edge busbar 102 is provided in the first edge region 120 to collect current from the segments of the disconnected finger electrodes 101 that are most adjacent to the first edge region 120. In addition, the edge solder pads 103 are also provided in the central region 130 rather than in the first edge region 120, so that the solder ribbon subsequently connected to the edge solder pads 103 can be avoided to be located in the first edge region 120, thereby preventing crack of the solar cell base 100 due to stress concentration in the first edge region 120 during the process of welding the solder ribbon to the edge solder pads 103. The busbar electrodes include the first busbar electrode 115 and the second busbar electrode 125, and the solder ribbons include the first solder ribbon and the second solder ribbon.

Similarly, for the finger electrode 101 disconnected by the busbar electrode or solder ribbon that is most adjacent to the second edge region 140, the edge busbar 102 is provided in the second edge region 140 to collect current from the segments of the disconnected finger electrodes 101 that are most adjacent to the second edge region 140. In addition, the edge solder pads 103 are also provided in the central region 130 rather than in the second edge region 140, so that the solder ribbon subsequently connected to the edge solder pads 103 can be avoided to be located in the second edge region 140, thereby preventing crack of the solar cell base 100 due to stress concentration in the second edge region 140 during the process of welding the solder ribbon to the edge solder pads 103.

In some cases, if the total number of the first busbar electrodes 115 and the second busbar electrodes 125 is even, or the total number of the first solder ribbons and the second solder ribbons is even, referring to FIG. 1, either the first busbar electrode 115 or the second busbar electrode 125 is most adjacent to the first edge region 120, while the other in the first busbar electrode 115 and the second busbar electrode 125 is most adjacent to the second edge region 140. Alternatively, either the first solder ribbon or the second solder ribbon is most adjacent to the first edge region 120, while the other in the first solder ribbon and the second solder ribbon is most adjacent to the second edge region 140. As such, the edge busbar 102 located in the first edge region 120 and the edge busbar 102 located in the second edge region 140 collect current from finger electrodes 101 of different polarities. It should be noted that FIG. 1 only illustrates a single first busbar electrode 115 or a single second busbar electrode 125. In practical applications, there is no limitation on the number of first busbar electrodes 115 or second busbar electrodes 125 on the back surface 110.

In some other cases, referring to FIG. 2 and FIG. 3, if the total number of the first busbar electrodes and the second busbar electrodes is odd, or the total number of the first solder ribbons and the second solder ribbons is odd, the busbar electrode most adjacent to the first edge region 120 and the busbar electrodes most adjacent to the second edge region 140 are of the same polarity, i.e., both are first busbar electrodes or both are second busbar electrodes. Alternatively, the solder ribbon most adjacent to the first edge region 120 and the solder ribbon most adjacent to the second edge region 140 are of the same type, i.e., both are first solder ribbons or both are second solder ribbons. As such, the edge busbar 102 located in the first edge region 120 and the edge busbar 102 located in the second edge region 140 collect current from finger electrodes 101 of the same polarity. For example, the edge busbars 102 shown in FIG. 2 and FIG. 3 both collect current from the first finger electrodes 111.

The embodiments of the present disclosure are further described in detail below with reference to the accompanying drawings.

In some embodiments, referring to FIG. 1 or FIG. 3, and FIG. 4, where FIG. 4 is a schematic top view of a first connecting member in a back-contact solar cell provided by an embodiment of the present disclosure, the connecting member 104 can include at least one first connecting member 114. The first connecting member 114 includes a plurality of first bent segments 114a sequentially connected along the first direction X. In two ends of the first connecting member 114 opposite along the first direction, one end is connected to the edge busbar 102, and the other end is connected to the edge solder pad 103.

As such, the current from the edge busbar 102 can be transmitted to the edge solder pad 103 through the first connecting member 114. In addition, the plurality of first bent segments 114a in the first connecting member 114 not only increase the cross-sectional area of the first connecting member 114 itself but also increases the contact area between the first connecting member 114 and the edge solder pad 103, as well as the contact area between the first connecting member 114 and the edge busbar 102, thereby improving the current transmission efficiency and reducing the risk of disconnection in the current transmission path.

Additionally, the edge solder pad 103 is not only connected to at least one finger electrode 101 but also blocks finger electrodes 101 of opposite polarity, which are electrically insulated from the edge solder pad 103, from extending further toward the edge region. The first connecting member 114 provided in the area where the finger electrodes 101 of the opposite polarity cannot extend due to the blocking of the edge solder pad 103 can also improve the utilization rate of the back surface 110, for example, by increasing the distribution density of the finger electrodes 101 per unit area of the back surface 110.

It can be noted that, in FIG. 4, the plurality of first bent segments 114a in a single first connecting member 114 are divided with thick dashed lines.

Furthermore, in FIG. 1 and FIG. 3, the edge solder pad 103 is illustrated as being located on only one finger electrode 101 and blocking two finger electrodes 101 of opposite polarity to the finger electrode 101 where the edge solder pad 103 is located, and thus two first connecting members 114 are provided corresponding to the two blocked finger electrodes 101 of opposite polarity. In practical applications, the edge solder pad 103 can be located on only one finger electrode 101 and block only one finger electrode 101 of opposite polarity, in which case one first connecting member 114 can be provided corresponding to the blocked finger electrode of opposite polarity. Alternatively, the edge solder pad 103 can be located on a plurality of finger electrodes 101 and block a plurality of finger electrodes 101 of opposite polarity, in which case a plurality of first connecting members can be provided corresponding to the blocked finger electrodes of opposite polarity. The embodiments of the present disclosure do not limit the number of finger electrodes 101 covered by a single edge solder pad 103, which can be adjusted based on the specific sizes of the edge solder pad 103.

In some embodiments, referring to FIG. 2 or FIG. 3, and FIG. 5, where FIG. 5 is a schematic top view of a second connecting member in a back-contact solar cell provided by an embodiment of the present disclosure, the connecting member 104 can include at least one second connecting member 124. The second connecting member 124 includes a plurality of second bent segments 124a sequentially connected along the second direction Y. In two ends of the second connecting member 124 opposite along the second direction Y, one end is connected to the edge solder pad 103, and the other end is connected to the one finger electrode 101.

As such, the current from the finger electrode 101 adjacent to the edge solder pad 103 can be transmitted to the edge solder pad 103 through the connecting member 104. In addition, the plurality of second bent segments 124a in the second connecting member 124 not only increase the cross-sectional area of the second connecting member 124 itself but also increases the contact area between the second connecting member 124 and the edge solder pad 103, as well as the contact area between the second connecting member 124 and the finger electrode 101, thereby improving the current transmission efficiency and reducing the risk of disconnection in the current transmission path.

Additionally, when welding a solder ribbon to the edge solder pad 103, the finger electrode 101 adjacent to the edge solder pad 103 may be damaged due to the influence of welding temperature and welding stress. If the finger electrode 101 breaks, the current from certain areas around the finger electrode 101 cannot be collected by the edge busbar 102. On this basis, the second connecting member 124 that connects the edge solder pad 103 to a finger electrode 101 adjacent to the edge solder pad 103 facilitates direct transmission of the current from that finger electrode 101 to the edge solder pad 103 through the second connecting member 124, avoiding current loss due to breakage of the finger electrode 101, and eliminates the need to collect current via the edge busbar 102 before transmitting to the edge solder pad 103.

It should be noted that, in FIG. 5, the plurality of second bent segments 124a in a single second connecting member 124 are divided with thick dashed lines, and to clearly illustrate the second bent segments 124a, the second connecting member 124 is filled up with a white color.

In some cases, referring to FIG. 2, the second connecting member 124 can also be located under the edge solder pad 103 and connected to the finger electrode 101 covered by the edge solder pad 103, ensuring the connection strength between the edge solder pad 103 and the finger electrodes 101, as well as between the connection strength between the edge solder pad 103 and the second connecting member 124, thereby further reducing the risk that current from certain finger electrodes 101 cannot be transmitted to the edge solder pad 103.

In some cases, referring to FIG. 3, two second connecting members 124, spaced apart from each other along the second direction Y, can be disposed between a single edge solder pad 103 and a finger electrode 101, thereby further ensuring that the current from that finger electrode 101 can be transmitted to the edge solder pad 103, effectively avoiding current loss due to breakage of the finger electrode 101.

In some other embodiments, referring to FIG. 3, the connecting member 104 can simultaneously include at least one first connecting member 114 and at least one second connecting member 124. The first connecting member 114 includes a plurality of first bent segments 114a sequentially connected along the first direction X. In two ends of the first connecting member 114 opposite along the first direction, one end is connected to the edge busbar 102, and the other end is connected to the edge solder pad 103. The second connecting member 124 includes a plurality of second bent segments 124a sequentially connected along the second direction Y. In two ends of the second connecting member 124 opposite along the second direction Y, one end is connected to the edge solder pad 103, and the other end is connected to the one finger electrode 101.

In some examples, in the second direction Y, the ratio of the width of the first connecting member 114 to the width of the finger electrode 101 can be in a range from 1 to 2. For example, the ratio of the width of the first connecting member 114 to the width of the finger electrode 101 can be 1.1, 1.2, 1.3, 1.4, 1.5, 1.6, 1.7, 1.8, 1.9, etc.

In some examples, the ratio of the width of the second connecting member 124 in the first direction X to the width of the finger electrode 101 in the second direction Y can be in a range from 1 to 2. For example, the ratio of the width of the second connecting member 124 in the first direction X to the width of the finger electrode 101 in the second direction Y can be 1.1, 1.2, 1.3, 1.4, 1.5, 1.6, 1.7, 1.8, 1.9, etc.

In some embodiments, referring to FIG. 1, the edge solder pad 103 can include a first solder pad 113 and a second solder pad 123. The first solder pad 113 is electrically connected to the first finger electrodes 111 and electrically insulated from the second finger electrodes 121. The second solder pad 123 is electrically connected to the second finger electrodes 121 and electrically insulated from the first finger electrodes 111. Referring to FIG. 1 and FIG. 3, the second connecting member 124 connected to the first solder pad 113 is also connected to at least one first finger electrode 111. The second connecting member 124 connected to the second solder pad 123 is also connected to at least one second finger electrode 121.

It can be noted that the second connecting member 124 can also cover at least one finger electrode 101 of the same polarity which is adjacent to and spaced apart from the edge solder pad 103. FIG. 3 illustrates an example where the second connecting member 124 covers one finger electrode 101 of the same polarity which is adjacent to and spaced apart from the edge solder pad 103. In practical applications, based on variations in the size of the edge solder pad 103, there is no limitation on the number of finger electrodes 101 of the same polarity adjacent to and spaced apart from the edge solder pad 103 that are covered by the second connecting member 124, and the number can be, for example, be 2, 3, 4, etc.

In some embodiments, referring to FIG. 1 to FIG. 3, the back-contact solar cell can further include a widen edge portion 106 extending along the first direction X. One end of the widen edge portion 106 is connected to the edge busbar 102, and the other end of the widen edge portion 106 is connected to the edge solder pad 103. Along the second direction Y, a first width of the widen edge portion 106 is greater than a second width of the finger electrode 101 connected to the edge solder pad 103.

It can be noted that compared to the current collected from the finger electrode 101 directly connected to the edge solder pad 103, the edge busbar 102 collects current from a plurality of finger electrodes 101, resulting in a greater current flow on the edge busbar 102. On this basis, the first width of the widen edge portion 106 is greater than the second width of the finger electrode 101 connected to the edge solder pad 103, resulting in a larger cross-sectional area of the widen edge portion 106, which reduces the transmission resistance thereof, thus matching the current flow on the edge busbar 102, improving the current transmission efficiency of the widen edge portion 106, thereby further enhancing the photoelectric conversion efficiency of the back-contact solar cell.

Moreover, the larger cross-sectional area of the widen edge portion 106 can increase the contact area between the widen edge portion 106 and the edge busbar 102, as well as the contact area between the widen edge portion 106 and the edge solder pad 103, thereby improving the connection strength between the widen edge portion 106 and the edge busbar 102, and improving the connection strength between the widen edge portion 106 and the edge solder pad 103, ensuring electrical connection between the edge busbar 102 and the edge solder pad 103.

In some embodiments, referring to FIG. 1 or FIG. 3, at least one first connecting member 114 is disposed on each of the two opposite sides of the widen edge portion 106 along the second direction Y, wherein along the first direction X, the first connecting member 114 is aligned with a finger electrode 101 that is electrically insulated from the edge solder pad 103.

It can be noted that the edge solder pad 103 not only blocks finger electrodes 101 of the opposite polarity that are electrically insulated from the edge solder pad 103 from extending further toward the edge region, but also blocks the finger electrode 101 of the same polarity that is directly connected to the edge solder pad 103 from extending further toward the edge region. The widen edge portion 106 is disposed in the area where the finger electrode 101 of the same polarity cannot extend due to the blocking of the edge solder pad 103 can also improve the utilization rate of the back surface 110. Moreover, along the first direction X, not only the first connecting member 114 is aligned with the finger electrode 101 that is electrically insulated from the edge solder pad 103, but also the widen edge portion 106 is aligned with the finger electrode 101 of the same polarity blocked by the edge solder pad 103.

It should be noted that, FIG. 1 and FIG. 3 illustrate examples where a single edge solder pad 103 blocks one finger electrode 101 of the same polarity and two finger electrodes 101 of opposite polarity, with one widen edge portion 106 and two first connecting members 114 connected to the edge solder pad 103. In practical applications, based on the specific location and sizes of the edge solder pad 103 on the back surface 110, there is no limitation on the number of finger electrodes of the same polarity or opposite polarity blocked by a single edge solder pad 103. The number of widen edge portions 106 can be adjusted based on the number of finger electrodes of the same polarity blocked by the edge solder pad 103, and the number of first connecting members 114 can be adjusted based on the number of finger electrodes of the opposite polarity blocked by the edge solder pad 103.

In some examples, along the second direction Y, the ratio of the width of the widen edge portion 106 to the width of the finger electrode 101 can be in a range from 5 to 30, for example, the ratio of the width of the widen edge portion 106 to the width of the finger electrode 101 can be 6, 8, 10, 12, 15, 16, 20, 24, 25, 28, etc.

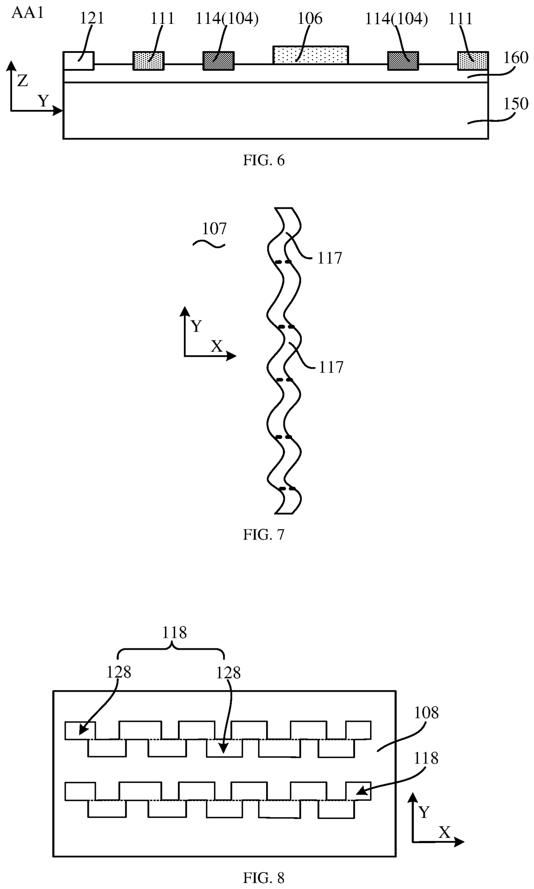

In some embodiments, referring to FIG. 6, where FIG. 6 is a schematic cross-sectional partial view of the back-contact solar cell shown in FIG. 3 along the first cross-sectional direction A-A1, the solar cell base 100 can include a substrate 150 and a passivation layer 160 located on a surface of the substrate 150, and the connecting member 104 and the finger electrodes 101 are all partially embedded in the passivation layer 160.

As such, the connecting member 104 not only transmits current from the edge busbar 102 or the finger electrode 101 to the edge solder pad 103 but also, like the finger electrode 101, collects photogenerated charge carriers from the substrate 150, thereby improving the collection efficiency of photogenerated charge carriers from the substrate 150. Furthermore, the orthographic projection of the connecting member 104 on the back surface 110 has a wavy shape, which, as compared with the substantially straight-line shaped orthographic projection of a finger electrode 101, increases the contact area between the connecting member 104 and the back surface 110. Thus, the connecting member 104 can collect photogenerated charge carriers from a larger area of the back surface 110, thereby further enhancing the collection efficiency of photogenerated charge carriers from the substrate 150 and improving the photoelectric conversion efficiency of the back-contact solar cell.

In some cases, the material of the connecting member 104 can be the same as that of the finger electrode 101. For example, the paste used for forming the connecting member 104 is the same as that used for forming the finger electrode 101, and both the connecting member 104 and the finger electrode 101 are made from a burn-through paste, allowing the connecting member 104 to penetrate the passivation layer 160. As such, the connecting member 104 not only transmits current from the edge busbar 102 or the finger electrode 101 to the edge solder pad 103 but can also independently collect photogenerated charge carriers from the substrate 150, thereby increasing the collection paths for photogenerated charge carriers and enhancing the photoelectric conversion efficiency of the back-contact solar cell.

In some cases, the passivation layer 160 can have a single-layer structure or a multi-layer structure, and the material of the passivation layer 160 can include at least one of silicon oxide, silicon nitride, silicon oxynitride, silicon carbon oxynitride, titanium oxide, hafnium oxide, or aluminum oxide.

In some cases, the substrate 150 has a first surface and a second surface opposite to each other. The first surface can have a textured structure. The textured structure increases the internal reflection of incident light, thereby reducing optical losses and improving the photoelectric conversion efficiency of the back-contact solar cell.

In some examples, the first surface has a front surface field (FSF), where the conductivity type of the doped ions in the first surface is the same as that of the doped ions in the substrate 150, reducing the minority carrier concentration at the surface due to the field passivation effect, thereby lowering the surface recombination rate, while also reducing series resistance and enhancing current transmission capability. The first surface is further covered with a first passivation layer and a first anti-reflective layer. The first passivation layer is located on the surface of the front surface field, and the first anti-reflective layer is located on the side of the first passivation layer facing away from the substrate 150. It should be noted that the substrate 150 does not necessarily include the front surface field, the first passivation layer, and the first anti-reflective layer.

In some examples, the second surface has alternately arranged first regions and second regions, where the first region is one of a P-type region or an N-type region, and the second region is the other of the P-type region or the N-type region, with a gap region between the P-type region and the N-type region. In other examples, there may be no gap region between the P-type region and the N-type region, and an insulating film layer is provided between the P-type region and the N-type region for electrical insulation, thereby realizing electrical insulation between the first finger electrodes 111 and the second finger electrodes 121. The first finger electrodes 111 can be located in one of the first region or the second region, and the second finger electrodes 121 can be located in the other of the first region or the second region.

In some examples, the gap region can be flush with the P-type region and the N-type region, meaning that the substrate 150 is not etched, and the electrical insulation between the P-type region and the N-type region can be achieved through forming some insulating films or layers, which can be passivation layers or intrinsic semiconductor layers. In some other examples, the gap region can be lower than the P-type region and the N-type region, meaning that the gap region is a groove extending from the second surface toward the first surface. The groove can physically isolate regions of different conductivity types, eliminating current leakage issues caused by the formation of a PN junction between a heavily doped P-type region and a heavily doped N-type region in the back-contact solar cell, which could affect the efficiency of the solar cell.

In some examples, the surface of the gap region can have a polished surface structure or a textured surface structure.

In some examples, the P-type region and the N-type region can each be covered with a tunneling silicon oxide layer and a doped polysilicon layer, where the P-type region is covered with a P-type doped polysilicon layer, and the N-type region is covered with an N-type doped polysilicon layer. In some other examples, the P-type region and the N-type region can each be covered with an intrinsic amorphous silicon layer, a doped amorphous silicon layer, and a transparent conductive layer, where the P-type region is covered with a P-type doped amorphous silicon layer, and the N-type region is covered with an N-type doped amorphous silicon layer.

In some embodiments, a second passivation layer and a second anti-reflective layer are disposed on the P-type region, the N-type region, and the gap region. The first finger electrodes 111 and the finger electrodes 121 are disposed on the second anti-reflective layer and embedded in the second passivation layer. It should be noted that the second passivation layer is the above-mentioned passivation layer 106.

In other embodiments, the material of the connecting member 104 can be the same as that of the first busbar electrode 115. For example, the paste used for forming the connecting member 104 is the same as that used for forming the first busbar electrode 115, and both the connecting member 104 and the first busbar electrode 115 are made from a non-burn-through paste. As such, the connecting member 104 is located on the surface of the passivation layer 106 without being embedded therein, which eliminates the need to modify the layout of the first region and the second region on the substrate surface under the connecting member to prevent electrical contact and short-circuiting between the connecting member and a doped region of the opposite polarity. Additionally, the connecting member 104 does not damage the passivation layer 106, thereby ensuring the integrity of the film structure of the passivation layer 106, enhancing the passivation effect of the passivation layer 106 on the substrate, and helping to reduce optical losses in the back-contact solar cell, thus improving the photoelectric conversion efficiency of the back-contact solar cell. Furthermore, since the non-burn-through paste contains less glass frit, which could otherwise damage the PN junction, the metal recombination can be effectively reduced, thereby increasing the open-circuit voltage of the back-contact solar cell, and enhancing the conversion efficiency of the back-contact solar cell.

It can be noted that a conventional paste typically includes a mixture of metal powder, glass frit, and an organic carrier. The non-burn-through paste refers to a paste with a lower glass frit content than the conventional paste, exhibiting weak burn-through capability during sintering, such that the paste does not need to or cannot burn through the passivation layer. The burn-through paste, on the other hand, refers to a paste with strong burn-through capability during sintering, capable of penetrating the passivation layer.

In practical applications, the connecting member 104 can alternatively be a film or a layer made of a conductive material or a conductive wire, as long as the current can be transmitted from the edge busbar 102 or the finger electrode 101 to the edge solder pad 103 via the connecting member 104.

In some embodiments, referring to FIG. 2 or FIG. 3, one edge solder pad 103 is electrically connected to one of the first finger electrode 111 or the second finger electrode 121 and electrically insulated from the other of the first finger electrode 111 or the second finger electrode 121. At least one finger electrode 101 adjacent to the edge solder pad 103 and electrically insulated from the edge solder pad 103 has a disconnection point. In some cases, referring to FIG. 2, the edge solder pad 103 is located at the disconnection point of the finger electrode 101; in other cases, referring to FIG. 3, the connecting member 104 is located at the disconnection point of the finger electrode 101.

Referring still to FIG. 2 or FIG. 3, the photovoltaic cell can further include a connection electrode 107, wherein in two ends of the connection electrode 107 opposite along the second direction Y, one end is connected to the finger electrode 101 having the disconnection point, and the other end is connected to another finger electrode 101 adjacent to the finger electrode 101 having the disconnection point along the second direction Y. As such, the connection electrode 107 can be used to connect a finger electrode 101 of the opposite polarity, which is disconnected by the edge solder pad 103 or the connecting member 104, to another adjacent finger electrode 101 of the opposite polarity. Thus, the current can be collected from the finger electrode 101 of the opposite polarity which is disconnected by the edge solder pad 103 or the connecting member 104, further improving the collection efficiency of photogenerated charge carriers in the substrate 150, thereby enhancing the photoelectric conversion efficiency of the back-contact solar cell.

In some cases, referring to FIG. 7, where FIG. 7 is a schematic top view of a connection electrode in a back-contact solar cell provided by an embodiment of the present disclosure, the connection electrode 107 can include a plurality of third bent segments 117 sequentially connected along the second direction Y. For example, the orthographic projection of the connection electrode 107 on the back surface 110 has a wavy shape. Thus, not only the cross-sectional area of the connection electrode 107 can be increased, which reduces the transmission resistance of the connection electrode 107 itself and improves the current transmission efficiency of the connection electrode 107, but also the contact area between the connection electrode 107 and the finger electrode 101 can be increased, which reduces the contact resistance between the connection electrode 107 and the finger electrode 101.

Additionally, the orthographic projection of the connection electrode 107 on the back surface 110 has a wavy shape, which, as compared with the substantially straight-line shaped orthographic projection of a finger electrode 101, not only reduces the risk of breaking the connection electrode 107 under stress by increasing the cross-sectional area thereof but also reduces the risk of disconnection between the connection electrode 107 and the finger electrode 101 by increasing the contact area therebetween.

It should be noted that, in FIG. 7, the plurality of third bent segments 117 in a single connection electrode 107 are divided with thick dashed lines.

In summary, on the one hand, the electric current is transmitted from the edge busbar 102 or finger electrodes 101 to the edge solder pad 103 through the connecting member 104, which forms more current flow paths on the back surface 110 through the connecting member 104, thereby enhancing the current collection efficiency of the edge solder pad 103. On the other hand, the orthographic projection of the connecting member 104 on the back surface 110 has a wavy shape, which, as compared with the substantially straight-line shaped orthographic projection of a finger electrode 101, increases the cross-sectional area of the connecting member 104 itself, the contact area between the connecting member 104 and the edge solder pad 103, as well as the contact area between the connecting member 104 and the edge busbar 102 or the finger electrode 101, thereby improving the current transmission efficiency of the connecting member 104 and further reducing the transmission resistance during current transmission from the edge busbar 102 or the finger electrode 101 to the edge solder pad 103. As a result, these combined effects contribute to enhancing the current collection efficiency of the back-contact solar cell, thereby improving the photoelectric conversion efficiency of the solar cell.

Additionally, on the one hand, the orthographic projection of the connecting member 104 on the back surface 110 has a wavy shape, which, as compared with the substantially straight-line shaped orthographic projection of a finger electrode 101, not only reduces the risk of breaking the connecting member 104 under stress but also reduces the risk of disconnection between the connecting member 104 and the edge solder pad 103, as well as between the connecting member 104 and the edge busbar 102 or the finger electrode 101. On the other hand, the edge solder pad 103 is not disposed on but electrically connected to the edge busbar 102, which allows a solder ribbon connected to the edge solder pad 103 not to be located in the first edge region 120 or the second edge region 140, thereby preventing micro-cracking issues on the edge of the back-contact solar cell. As a result, these combined effects contribute to improving the yield of the back-contact solar cell.

According to some embodiments of the present disclosure, another aspect of the embodiments of the present disclosure further provides a method for preparing a back-contact solar cell, which can be used to prepare the back-contact solar cell provided in the above-described embodiments. The method for preparing the back-contact solar cell in the embodiment of the present disclosure will be described in detail below with reference to the accompanying drawings. It should be noted that parts identical or corresponding to the above-described embodiments will not be reiterated herein.

Referring to FIG. 1 to FIG. 9, the method for preparing the back-contact solar cell can include the following steps:
providing a solar cell base 100, wherein a back surface 110 of the solar cell base 100 includes a first edge region 120, a central region 130, and a second edge region 140 sequentially arranged along a first direction X;
forming first finger electrodes 111, second finger electrodes 121, and a connecting member 104 in the central region 130, wherein the first finger electrodes 111 and at least part of the connecting member 104 are formed in a same preparation process, and/or the second finger electrodes 121 and at least part of the connecting member 104 are formed in another same preparation process, the first finger electrodes 111 and the second finger electrodes 121 being alternately arranged along a second direction Y, and an orthographic projection of the connecting member 104 on the back surface 110 having a wavy shape;
forming an edge busbar 102 in the first edge region 120 or the second edge region 140, the edge busbar 102 extending along the second direction Y and being connected to the first finger electrodes 111 or the second finger electrodes 121;
forming an edge solder pad 103, the edge solder pad 103 being located on a portion of at least one finger electrode 101 adjacent to the first edge region 120 or the second edge region 140 and electrically connected to the edge busbar 102, the finger electrode 101 being one of the first finger electrodes 111 or the second finger electrodes 121;
wherein one end of the connecting member 104 is connected to a side of the edge solder pad 103 adjacent to the edge busbar 102 or to one of two opposite sides of the edge solder pad 103 along the second direction Y; and another end of the connecting member 104 is connected to the edge busbar 102 adjacent to the edge solder pad 103 or one finger electrode 101.

It should be noted that some connecting members 104 can be formed in the same step with preparing the first finger electrodes 111, and/or some connecting members 104 can be formed in the same step with preparing the second finger electrodes 121, which simplifies the preparation process for forming the connecting members 104.

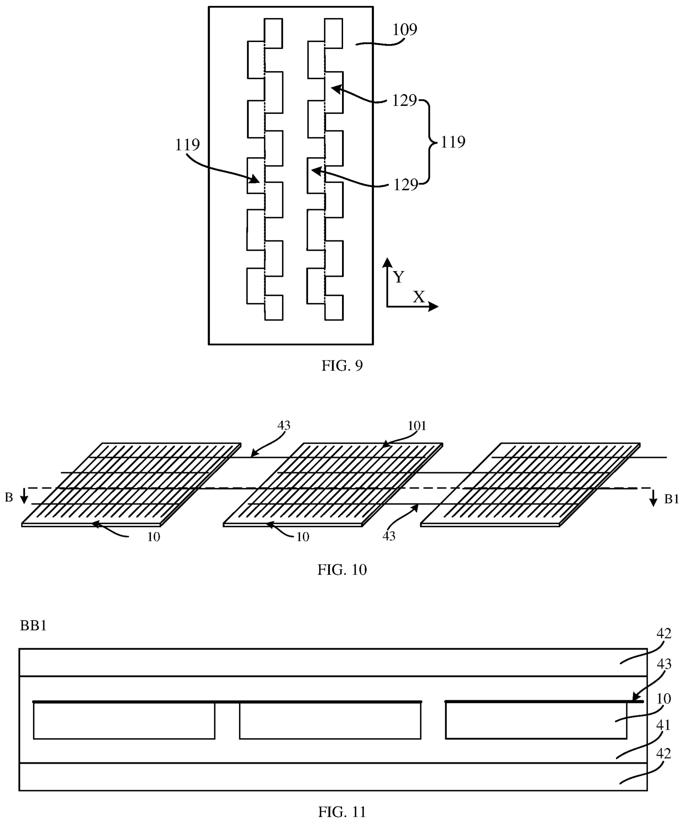

FIG. 8 is a schematic top partial view of a first screen in a method for preparing a back-contact solar cell provided by another embodiment of the present disclosure. FIG. 9 is a schematic top partial view of a second screen in a method for preparing a back-contact solar cell provided by another embodiment of the present disclosure.

In some embodiments, referring to FIG. 8 and FIG. 1, or FIG. 8 and FIG. 3, the step of forming the connecting member 104 can include: providing a first screen 108 and printing a paste on the first screen 108 to form at least one first connecting member 114, wherein the first connecting member 114 includes a plurality of first bent segments 114a sequentially connected along the first direction X; in two ends of the first connecting member 114 opposite along the first direction, one end is connected to the edge busbar 102, and the other end is connected to the edge solder pad 103. As such, with the plurality of first bent segments 114a sequentially connected along the first direction X, the orthographic projection of the first connecting member 114 on the back surface 110 can have a wavy shape.

In some cases, the step of providing the first screen 108 can include: providing the first screen 108 having at least one first opening 118, wherein one first opening 118 is configured to form one first connecting member 114, the first opening 118 including a plurality of first sub-openings 128 sequentially communicated along the first direction X, and two adjacent first sub-openings 128 are arranged along the second direction Y and staggered with each other.

It can be noted that the first connecting member 114 can be prepared together with the finger electrodes 101. Therefore, the first screen 108 can further include third openings for forming the finger electrodes 101, which are generally line-shaped narrow openings extending along the first direction X. When the first opening 118 and the third openings are prepared simultaneously on the first screen 108, due to process limitations, the first opening 118 is more easily formed as a plurality of short first sub-openings 128 along the first direction X, and two adjacent first sub-openings 128 are arranged along the second direction Y and staggered with each other. As such, the first connecting member 114 with a wavy shaped orthographic projection on the back surface 110 can be formed through the first opening 118.

In some embodiments, referring to FIG. 9 and FIG. 2, or FIG. 9 and FIG. 3, the step of forming the connecting member 104 can include: providing a second screen 109 and printing a paste on the second screen 109 to form at least one second connecting member 124, wherein the second connecting member 124 includes a plurality of second bent segments 124a sequentially connected along the second direction Y; in two ends of the second connecting member 124 opposite along the second direction Y, one end is connected to the edge solder pad 103, and the other end is connected to one finger electrode 101. As such, with the plurality of second bent segments 124a sequentially connected along the second direction Y, the orthographic projection of the second connecting member 124 on the back surface 110 can have a wavy shape.

In some cases, the step of providing the second screen 109 can include: providing the second screen 109 having at least one second opening 119, wherein one second opening 119 is configured to form one second connecting member 124, the second opening 119 including a plurality of second sub-openings 129 sequentially communicated along the second direction Y, and two adjacent second sub-openings 129 are arranged along the first direction X and staggered with each other.

It can be noted that the second connecting member 124 can be prepared together with the finger electrodes 101. Therefore, the second screen 109 can further include third openings for forming the finger electrodes 101, which are generally line-shaped narrow openings extending along the first direction X. When the second opening 119 and the third openings are prepared simultaneously on the second screen 109, due to process limitations, the second opening 119 is more easily formed as a plurality of short second sub-openings 129 along the first direction X, and two adjacent second sub-openings 129 are arranged along the first direction X and staggered with each other. As such, the second connecting member 124 with a wavy shaped orthographic projection on the back surface 110 can be formed through the second opening 119.

It should be noted that, in the same back-contact solar cell, the connecting member 104 can include only at least one first connecting member 114, or only at least one second connecting member 124, or both at least one first connecting member 114 and at least one second connecting member 124.

In some cases, in the same back-contact solar cell, a plurality of connecting members 104 can all be electrically connected to the finger electrodes 101 of the same polarity. For example, all connecting members 104 can be electrically connected to either the first finger electrodes 111 or the second finger electrodes 121. In some other cases, in the same back-contact solar cell, some connecting members 104 can be electrically connected to the first finger electrodes 111, while the other connecting members 104 can be electrically connected to the second finger electrodes 121. In either case, the first finger electrodes 111, the second finger electrodes 121, and the connecting members 104 can all be formed in the same preparation process. Thus, the first openings 118 in the first screen 108 and the second openings 119 in the second screen 109 can be integrated into a single screen, which also includes third openings for preparing the finger electrodes 101.

In summary, in the method for preparing the back-contact solar cell provided by the embodiment of the present disclosure, the connecting member 104 and the finger electrodes 101 can be formed in a same preparation process, which not only simplifies the preparation process for forming the connecting member 104 but also facilitates the formation of a connecting member 104 with a wavy shaped orthographic projection on the back surface 110.

According to some embodiments of the present disclosure, yet another aspect of the embodiments of the present disclosure further provides a photovoltaic module, formed by connecting a plurality of back-contact solar cells provided in the above-described embodiments or by connecting a plurality of back-contact solar cells prepared by the preparation methods provided in the above-described embodiments. The photovoltaic module provided by the embodiments of the present disclosure will be described below with reference to the accompanying drawings. It should be noted that parts identical or corresponding to the above-described embodiments will not be reiterated herein.

Referring to FIG. 10, FIG. 11, and FIG. 1 to FIG. 3, the photovoltaic module includes a solar cell string, an encapsulant film 41, and a cover plate 42. The solar cell string includes a plurality of back-contact solar cells as described in any one of the above embodiments, or includes a plurality of back-contact solar cells prepared by the preparation method as described in any one of the above embodiments, wherein the plurality of back-contact solar cells are connected with each other. The encapsulant film 41 is configured to cover a surface of the solar cell string. The cover plate 42 is configured to cover a surface of the encapsulant film 41 facing away from the solar cell string.

FIG. 10 is a schematic structural perspective partial view of a photovoltaic module provided by yet another embodiment of the present disclosure. FIG. 11 is a schematic cross-sectional partial view of the photovoltaic module shown in FIG. 10 along the second cross-sectional direction B-B1.

In some embodiments, the back-contact solar cells 10, referred to as BC solar cells, can include but is not limited to interdigitated back-contact (IBC) solar cells, heterojunction back-contact (HBC) solar cells, TOPCon back-contact (TOPCon BC) solar cells, referring to the interdigitated passivated back-contact solar cells, or hybrid passivated back-contact (HPBC) solar cells. Additionally, the back-contact solar cells 10, which can be complete whole cells or sliced cells, are electrically connected to form a plurality of solar cell strings, and the plurality of solar cell strings are electrically connected in series and/or parallel. The back-contact solar cell 10 can be a complete whole cell or a sliced cell, the sliced cell referring to a solar cell formed by cutting a complete whole cell through a cutting process.

In some embodiments, referring to FIG. 10 or FIG. 11, the plurality of back-contact solar cells 10 can be electrically connected through electrically conductive ribbons 43. FIG. 10 and FIG. 11 only exemplarily show one positional relationship between the back-contact solar cells 10. The back-contact solar cells 10 can alternatively be arranged such that the finger electrodes of different polarities face the same side, i.e., the finger electrodes of adjacent back-contact solar cells 10 are sequentially arranged in the order of first polarity, second polarity, and first polarity. In this case, the conductive ribbon 43 connects the same side of two adjacent back-contact solar cells 10.

In some embodiments, the encapsulant film 41 includes a first encapsulation layer and a second encapsulation layer, wherein the first encapsulation layer covers one of the front surface or the back surface of the back-contact solar cell 10, and the second encapsulation layer covers the other of the front surface or the back surface of the back-contact solar cell 10. Specifically, at least one of the first encapsulation layer or the second encapsulation layer can be an organic encapsulant film, such as a polyvinyl butyral (PVB) film, an ethylene-vinyl acetate (EVA) film, a polyolefin elastomer (POE) film, or a polyethylene terephthalate (PET) film. Alternatively, at least one of the first encapsulation layer or the second encapsulation layer can be an EP film, an EPE film, or a PVP film. The EP film refers to a co-extruded film composed of an EVA film and a POE film laminated with each other. The EPE film refers to a co-extruded film composed of an EVA film, a POE film, and an EVA film sequentially laminated with each other. The PVP film refers to a co-extruded film composed of a POE film, an EVA film, and a POE film sequentially laminated with each other. The co-extruded film can be prepared by sequentially extruding one or more raw materials onto another pre-formed film during the film processing, or by bonding a plurality of pre-formed films together.

In some cases, the first encapsulation layer and the second encapsulation layer have a distinct boundary before lamination. After the lamination process to form the photovoltaic module, the separate first and second encapsulation layers no longer exist, as the first encapsulation layer and the second encapsulation layer are formed into an integrated encapsulant film 41.

In some embodiments, the cover plate 42 can be a glass cover plate, a plastic cover plate, or other light-transmitting cover plates. Specifically, the surface of the cover plate 42 facing the encapsulant film 41 can be a surface with concave and convex structures or a textured surface including multiple protruding structures, thereby increasing the utilization rate of incident light. The cover plate 42 includes a first cover plate and a second cover plate, wherein the first cover plate corresponds to the first encapsulation layer, and the second cover plate corresponds to the second encapsulation layer.

In some cases, when the back-contact solar cell 10 includes busbar electrodes, on the surface of the back-contact solar cell 10, the plurality of busbar electrodes are spaced apart from each other along the first direction and the plurality of finger electrodes are spaced apart from each other along the second direction. The busbar electrodes include busbar electrode connection lines and solder pads located on the busbar electrode connection lines. In the process of forming a solar cell string with the back-contact solar cells 10, the conductive ribbon 43 is electrically connected to at least one busbar electrode in each of the two adjacent back-contact solar cells 10.

In some other cases, when the back-contact solar cell 10 does not include busbar electrodes, on the surface of the back-contact solar cell 10, the plurality of finger electrodes can be spaced apart from each other along a third direction Z. In the process of forming a solar cell string with the back-contact solar cells 10, the conductive ribbon 43 is electrically connected to the plurality of finger electrodes in each of the two adjacent back-contact solar cells 10.

## Claims

1. A back-contact solar cell (10), comprising:
a solar cell base (100), a back surface (110) of the solar cell base (100) comprising a first edge region (120), a central region (130), and a second edge region (140) sequentially arranged along a first direction;
first finger electrodes (111) and second finger electrodes (121) located in the central region and alternately arranged along a second direction;
an edge busbar (102) extending along the second direction, located in the first edge region (120) or the second edge region (140), and connected to the first finger electrodes (111) or the second finger electrodes (121);
an edge solder pad (103) located on a portion of at least one finger electrode adjacent to the first edge region (120) or the second edge region (140) and electrically connected to the edge busbar (102), the finger electrode being one of the first finger electrode or the second finger electrode; and
a connecting member (104), an orthographic projection of the connecting member (104) on the back surface (110) having a wavy shape;
wherein one end of the connecting member (104) is connected to a side of the edge solder pad (103) adjacent to the edge busbar (102) or to one of two opposite sides of the edge solder pad (103) along the second direction; and another end of the connecting member (104) is connected to the edge busbar (102) or to one finger electrode.

2. The back-contact solar cell (10) according to claim 1, wherein the connecting member (104) comprises:
at least one first connecting member (104), the first connecting member (104) comprising a plurality of first bent segments sequentially connected along the first direction, in two ends of the first connecting member (104) opposite along the first direction, one end being connected to the edge busbar (102), and the other end being connected to the edge solder pad (103); preferably, in the second direction, a ratio of a width of the first connecting member to a width of the finger electrode is in a range from 1 to 2.

3. The back-contact solar cell (10) according to claim 1 or 2, wherein the connecting member (104) comprises: at least one second connecting member (104), the second connecting member (104) comprising a plurality of second bent segments sequentially connected along the second direction, in two ends of the second connecting member (104) opposite along the second direction, one end being connected to the edge solder pad (103), and the other end being connected to the one finger electrode; preferably, a ratio of a width of the second connecting member in the first direction to a width of the finger electrode in the second direction is in a range from 1 to 2.

4. The back-contact solar cell (10) according to claim 3, wherein the edge solder pad (103) comprises a first solder pad and a second solder pad, the first solder pad is electrically connected to the first finger electrodes (111) and electrically insulated from the second finger electrodes (121), and the second solder pad is electrically connected to the second finger electrodes (121) and electrically insulated from the first finger electrodes (111); the second connecting member (104) connected to the first solder pad is also connected to at least one first finger electrode; and
the second connecting member (104) connected to the second solder pad is also connected to at least one second finger electrode.

5. The back-contact solar cell (10) according to any one of claims 2 to 4, further comprising a widen edge portion (106) extending along the first direction;
wherein one end of the widen edge portion (106) is connected to the edge busbar (102), and the other end of the widen edge portion (106) is connected to the edge solder pad (103); along the second direction, a first width of the widen edge portion (106) is greater than a second width of the finger electrode connected to the edge solder pad (103); and/or
wherein at least one first connecting member (104) is disposed on each of two opposite sides of the widen edge portion (106) along the second direction, wherein along the first direction, the first connecting member (104) is aligned with a finger electrode that is electrically insulated from the edge solder pad (103).

6. The back-contact solar cell (10) according to claim 5, wherein a ratio of the first width to the second width is in a range from 5 to 30.

7. The back-contact solar cell (10) according to any one of claims 1 to 6, wherein the solar cell base (100) comprises a substrate and a passivation layer located on a surface of the substrate, the connecting member (104) and the finger electrodes are all partially embedded in the passivation layer.

8. The back-contact solar cell (10) according to claim 7, wherein a material of the connecting member (104) is the same as a material of the finger electrode (101); preferably the connecting member (104) and the finger electrode (101) are made from a burn-through paste.

9. The back-contact solar cell (10) according to any one of claims 1 to 8, wherein one edge solder pad (103) is electrically connected to one of the first finger electrodes (111) or the second finger electrodes (121) and electrically insulated from the other of the second finger electrodes (121) or the first finger electrodes (111); at least one finger electrode adjacent to the edge solder pad (103) and electrically insulated from the edge solder pad (103) has a disconnection point, and the edge solder pad (103) or the connecting member (104) is located at the disconnection point of the finger electrode;
the back-contact solar cell (10) further comprises a connection electrode (107), wherein in two ends of the connection electrode (107) opposite along the second direction, one end is connected to the finger electrode having the disconnection point, and the other end is connected to another finger electrode adjacent to the finger electrode having the disconnection point along the second direction.

10. The back-contact solar cell (10) according to claim 9, wherein the connection electrode (107) comprises a plurality of third bent segments (117) sequentially connected along the second direction.

11. The back-contact solar cell (10) according to any one of claims 1 to 10, comprising first busbar electrodes (115) and second busbar electrodes (125) located in the central region and alternately arranged along the first direction X, wherein the first busbar electrodes (115) are electrically connected to the first finger electrodes and electrically insulated from the second finger electrodes, and the second busbar electrodes (125) are electrically connected to the second finger electrodes and electrically insulated from the first finger electrodes; preferably, central solder pads (113) are in contact with the first busbar electrodes (115) or the second busbar electrodes (125).

12. A method for preparing a back-contact solar cell (10), comprising:
providing a solar cell base (100), a back surface (110) of the solar cell base (100) comprising a first edge region (120), a central region (130), and a second edge region (140) sequentially arranged along a first direction;
forming first finger electrodes (111), second finger electrodes (121), and a connecting member (104) in the central region, wherein the first finger electrodes (111) and at least part of the connecting member (104) are formed in a same preparation process, and/or the second finger electrodes (121) and at least part of the connecting member (104) are formed in another same preparation process, the first finger electrodes (111) and the second finger electrodes (121) being alternately arranged along a second direction, and an orthographic projection of the connecting member (104) on the back surface (110) having a wavy shape;
forming an edge busbar (102) in the first edge region (120) or the second edge region (140), the edge busbar (102) extending along the second direction and being connected to the first finger electrodes (111) or the second finger electrodes (121);
forming an edge solder pad (103), the edge solder pad (103) being located on a portion of at least one finger electrode adjacent to the first edge region (120) or the second edge region (140) and electrically connected to the edge busbar (102), the finger electrode being one of the first finger electrode or the second finger electrode;
wherein one end of the connecting member (104) is connected to a side of the edge solder pad (103) adjacent to the edge busbar (102) or to one of two opposite sides of the edge solder pad (103) along the second direction; and another end of the connecting member (104) is connected to the edge busbar (102) or to one finger electrode.

13. The method according to claim 12, wherein the step of forming the connecting member (104) comprises:
providing a first screen (108) and printing a paste on the first screen (108) to form at least one first connecting member (104), the first connecting member (104) comprising a plurality of first bent segments sequentially connected along the first direction, in two ends of the first connecting member (104) opposite along the first direction, one end being connected to the edge busbar (102), and the other end being connected to the edge solder pad (103); and/or
providing a second screen (109) and printing a paste on the second screen (109) to form at least one second connecting member (104), the second connecting member (104) comprising a plurality of second bent segments sequentially connected along the second direction, in two ends of the second connecting member (104) opposite along the second direction, one end being connected to the edge solder pad (103), and the other end being connected to the one finger electrode;
wherein the connecting member (104) comprises the at least one first connecting member (104) and/or the at least one second connecting member (104).

14. The method according to claim 12 or 13, wherein the step of providing the first screen (108) comprises: providing the first screen (108) having at least one first opening, wherein one first opening is configured to form one first connecting member (104), the first opening comprising a plurality of first sub-openings sequentially communicated along the first direction, and two adjacent first sub-openings are arranged along the second direction and staggered with each other; and/or
the step of providing the second screen (109) comprises: providing the second screen (109) having at least one second opening, wherein one second opening is configured to form one second connecting member (104), the second opening comprising a plurality of second sub-openings sequentially communicated along the second direction, and two adjacent second sub-openings are arranged along the first direction and staggered with each other.

15. A photovoltaic module, comprising:
a solar cell string comprising a plurality of back-contact solar cells (10) according to any one of claims 1 to 11 or a plurality of back-contact solar cells (10) prepared by the method according to any one of claims 12 to 14, the plurality of back-contact solar cells (10) being connected with each other;
an encapsulant film (41) configured to cover a surface of the solar cell string; and
a cover plate (42) configured to cover a surface of the encapsulant film facing away from the solar cell string.
